## Europäisches Patentamt
## European Patent Office
## Office européen des brevets

(19)

(11) Numéro de publication: **0 019 511**
**B1**

(12) **FASCICULE DE BREVET EUROPEEN**

(45) Date de publication du fascicule du brevet:
**15.06.83**

(51) Int. Cl.³: **H 03 L 1/02,** G 01 L 11/00

(21) Numéro de dépôt: **80400575.9**

(22) Date de dépôt: **25.04.80**

(54) **Procédé de compensation des dérivés en temperature dans les dispositifs à ondes de surface et capteur de pression mettant en oeuvre ce procédé.**

(30) Priorité: **16.05.79 FR 7912458**

(43) Date de publication de la demande:
**26.11.80 Bulletin 80/24**

(45) Mention de la délivrance du brevet:
**15.06.83 Bulletin 83/24**

(84) Etats contractants désignés:
**DE GB IT NL SE**

(56) Documents cités:
**DE-A-2 754 669**
**FR-A-2 224 825**
**FR-A-2 374 625**
**GB-A-1 517 371**
**US-A-3 878 477**
**US-A-3 894 286**
**US-A-4 100 811**

(73) Titulaire: **THOMSON-CSF, 173, Boulevard Haussmann, F-75379 Paris Cedex 08 (FR)**

(72) Inventeur: **Hartemann, Pierre, "THOMSON-CSF" - SCPI 173, Bld Haussmann, F-75360 Paris Cedex 08 (FR)**

(74) Mandataire: **Wang, Pierre et al, THOMSON-CSF SCPI 173, Bld Haussmann, F-75379 Paris Cedex 08 (FR)**

BUNDESDRUCKEREI BERLIN

Procédé de compensation des dérives en température dans les dispositifs à ondes de
surface et capteur de pression mettant en oeuvre ce procédé

La présente invention concerne un procédé de compensation des dérives en température dans les dispositifs comprenant deux oscillateurs à ondes élastiques de surface dont les fréquences d'oscillation sont mélangées de façon à fournir la différence de ces fréquences.

Les ondes élastiques de surface pouvant se propager dans un substrat piézoélectrique sont utilisées pour de nombreuses applications et notamment, à l'aide des transducteurs à peignes interdigités, pour réaliser des lignes à retard ou des résonateurs bouclés au moyen d'amplificateurs en vue de réaliser des oscillateurs fonctionnant dans une gamme de très hautes fréquences (typiquement 100 MHz). La vitesse de propagation de ces ondes dans le substrat étant susceptible de varier avec différents paramètres physiques, comme l'accélération et la pression, de tels oscillateurs sont utilisés notamment dans les accéléromètres et les capteurs de pression et de force. Afin de réduire la fréquence du signal de sortie, de façon à l'exploiter plus facilement, les capteurs comprennent généralement deux oscillateurs dont les signaux de sortie ont des fréquences très voisines et par exemple varient en sens inverse avec le paramètre à mesurer. Des signaux sont mélangés, de façon à fournir un signal de sortie dont la fréquence est égale à la différence des deux fréquences d'oscillation et est donc très réduite (typiquement 100 KHz), et varie avec le paramètre à mesurer avec une sensibilité égale à la somme algébrique de celle de chaque oscillateur pris séparément, de façon quasi linéaire, tout au moins dans une gamme de valeurs prédéterminée.

En plus du paramètre à mesurer, les fréquences d'oscillation varient toujours de façon sensible avec la température. Le fait d'utiliser deux oscillateurs et de faire la différence des fréquences d'oscillation, dont les variations en fonction de la température sont de mêmes signes et de valeurs voisines, permet d'obtenir une dérive en température très réduite. Ce type de dispositif à deux oscillateurs est décrit dans le document US-A-4 100 811. Cependant, les dissymétries éventuelles du dispositif et les imperfections technologiques rendent souvent impossible de réduire suffisamment cette dérive, surtout lorsque les gammes de variations de température sont très importantes et il n'est pas toujours possible de placer le dispositif dans une enceinte thermostatée. Il en résulte des erreurs systématiques dans la mesure du paramètre à mesurer, ces erreurs pouvant atteindre le même ordre de grandeur que le paramètre lui-même.

L'invention vise à remédier à cet inconvénient par un procédé qui permet d'égaliser les dérives en température des deux oscillateurs associés. L'invention utilise les propriétés de certains milieux de propagation des signaux très haute fréquence tels que câbles coaxiaux, lignes à constantes localisées, qui présentent également des dérives en température, celles-ci pouvant être très importantes, et introduisent des retards suffisamment faibles pour que les fréquences d'oscillation ne soient que peu modifiées. L'invention a donc pour objet un procédé de compensation des dérives en température dans un dispositif comprenant deux oscillateurs à ondes élastiques de surface comportant chacun une ligne à retard ou un résonateur agencé sur un substrat piézoélectrique commun et des moyens mélangeurs fournissant un signal de sortie dont la fréquence est égale à la différence des fréquences d'oscillation des deux oscillateurs, ces deux oscillateurs présentant en raison de l'utilisation dudit substrat piézoélectrique commun des dérives en température de même signe et de valeurs très voisines, caractérisé en ce qu'il consiste à insérer dans la boucle de l'un au moins des oscillateurs un câble coaxial introduisant un retard variable avec la température, dont la longueur est choisie de façon que la variation du retard avec la température compense la différence initiale entre les dérives thermiques des deux oscillateurs.

L'invention a également pour objet un capteur de pression du type comprenant deux lignes à retard bouclées sur elles-mêmes respectivement par deux amplificateurs de manière à former deux boucles oscillatrices et des moyens mélangeurs fournissant un signal de sortie dont la fréquence est égale à la différence des fréquences d'oscillation desdites boucles; ces lignes étant disposées à la surface d'un substrat piézoélectrique de façon à présenter des retards variant en sens inverse avec la pression à mesurer tout en présentant des dérives thermiques de mêmes signes et de valeurs très voisines, caractérisé en ce que la différence constatée entre les dérives thermiques des deux boucles oscillatrices est compensée par un câble coaxial intercalé dans l'une au moins de celles-ci.

Elle s'applique également aux capteurs de force et aux accéléromètres.

D'autres caractéristiques et avantages de l'invention apparaîtront mieux à l'aide de la description ci-après, présentée à titre d'exemple non limitatif et des figures annexées:

— la figure 1 représente un capteur de pression à ondes élastiques de surface mettant en oeuvre le procédé selon l'invention;
— la figure 2 est un diagramme représentatif des dérives en température dans le dispositif de la figure 1.

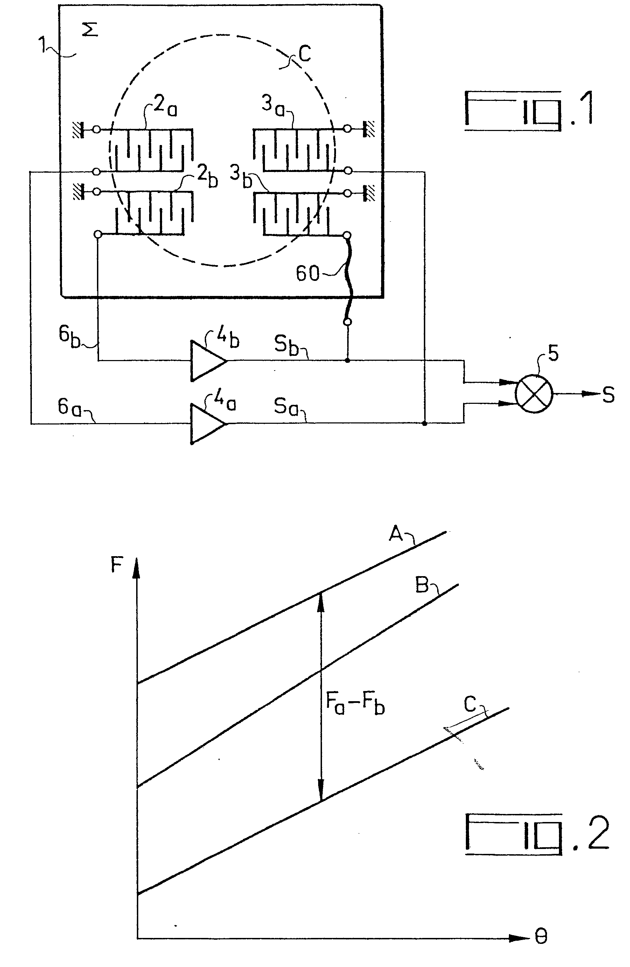

La figure 1 est une vue de dessus d'un capteur de pression formé avec deux lignes à retard propageant des ondes élastiques de surface, présenté à titre d'exemple non limitatif d'application de l'invention. Les lignes sont réalisées à la surface $\Sigma$ d'un substrat piézoélectrique. Parmi les matériaux piézoélectriques couramment utilisés, on peut citer notamment le quartz et le biobate de lithium, ce dernier présentant des dérives en température plus importantes que le premier. Le substrat a une forme rectangulaire. Il peut se présenter sous la forme d'une plaquette mince de forme rectangulaire dont les bords sont fixés rigidement sur un support. Ce support comporte un évidement central circulaire dont la trace C sur la plaquette est représentée en pointillés sur la figure 1. Le substrat peut également consister en un bloc plus épais et rigide, évidé en son centre de façon à ne laisser qu'un disque C de faible épaisseur. Dans les deux cas, la partie utile du substrat est le disque C. La face externe $\Sigma$ du substrat est polie et, dans la zone utile, sont disposés des paires de transducteurs $2a-3a-$ et $2b-3b$ entre lesquels sont respectivement formées deux lignes à retard. L'une des lignes a son axe de propagation confondu avec un diamètre du disque C. L'autre a son axe parallèle au précédent, proche de la périphérie de la zone utile, de sorte que les effets d'une différence de pression sur les contraintes imposées aux zones correspondantes de la plaquette soient de signes opposés et d'intensités voisines.

Les lignes sont bouclées sur elles-mêmes respectivement par des circuits amplificateurs $4a$ et $4b$. On obtient ainsi des oscillateurs a et b dont les signaux de sortie respectifs $S_a$ et $S_b$ ont des fréquences $F_a$ et $F_b$ voisines mais non égales, en raison notamment de l'influence des connexions et des déphasages introduits par les amplificateurs dans chaque boucle. De plus, ces fréquences varient en sens contraire avec la pression. Les signaux $S_a$ et $S_b$ sont mélangés dans un mélangeur 5 qui fournit le signal de sortie S, de fréquence $F_a-F_b$. Lorsque les variations de contraintes exercées sur le disque produisent des variations de fréquence, celles-ci étant de signes contraires, par exemple $\Delta F_a$ et $-\Delta F_b$, la variation de fréquence du signal S est égale à $\Delta F_a+\Delta F_b$. Par contre, des variations de température ambiante produisent des variations de fréquence de même signe: $\delta F_a$ et $\delta F_b$, si bien que la variation de fréquence du signe S est égale à $\delta F_a-\delta F_b$. Les deux lignes ayant les mêmes caractéristiques: même matériau, longueurs et fréquences de fonctionnement voisines, $\delta F_b$ est très proche de $\delta F_a$. Toutefois, comme ni les deux lignes, ni les boucles d'oscillation, ne sont rigoureusement identiques, la différence $\delta F_a-\delta F_b$ n'est pas nulle.

Le capteur décrit ci-dessus, en l'absence du procédé de compensation selon l'invention a été réalisé avec un substrat en quartz coupe Y évidé en son centre de façon à ménager une partie utile C de diamètre 10 mm et d'épaisseur 250 μm. La fréquence d'oscillation de chaque oscillateur est d'environ 100 MHz. La sensibilité obtenue est de 40 KHz/bar. On a mesuré une dérive en température:

$$\frac{\delta\,(F_a-F_b)}{F_a-F_b}$$

de $10^{-7}/°C$. On voit immédiatement que, lorsque la température varie, par exemple entre $-40°C$ et $+100°C$, la fréquence du signal de sortie varie de 1,4 KHz, correspondant à une erreur systématique sur la pression de 35 mm bar, ce qui n'est pas du tout négligeable par rapport aux pressions que l'on peut mesurer avec ce type de capteur.

L'invention vise à supprimer cette erreur systématique. Le capteur représenté sur la figure 1 met en oeuvre le procédé selon l'invention. Dans la boucle de l'un des oscillateurs, ici: b, est inséré en câble coaxial 60, se trouvant à la même température que les lignes, dont les caractéristiques: vitesse de propagation des signaux de fréquence $F_b$ et dérive en température sont connues, et dont la longueur 1 est déterminée de façon à rapprocher la dérive de l'oscillateur b, de celle de l'oscillateur a. Le mode de détermination de la longueur 1 est donné dans la suite de la description. Le câble 60 est à insérer dans la boucle de l'oscillateur qui dérive le plus si sa dérive est de même signe que celle des oscillateurs, et, dans le cas contraire, dans la boucle de l'oscillateur qui dérive le moins.

Le diagramme de la figure 2 représente les variations des fréquences d'oscillation de repos, c'est-à-dire pour une pression à mesurer nulle: $F_a$ et $F_b$, en fonction de la température $\Theta$, celle-ci variant dans une gamme prédéterminée. On a supposé sur la figure que ces variations sont linéaires, ce qui est conforme aux mesures effectuées sur un dispositif tel que décrit ci-dessus. La courbe A est la courbe de variation de la fréquence $F_a$. La courbe B est la courbe de variation de la fréquence $F_b$ en l'absence de compensation (sans le câble 60). On constate que le fréquence d'oscillation augmente avec la température. Cependant, conformément à ce qui a été dit plus haut, les pentes des deux courbes ne sont pas égales, si bien que l'écart entre les deux courbes, correspondant à la différence $F_a-F_b$ au repos varie avec la température. Dans le cas de la figure, cette différence diminue avec la température car la dérive de $F_b$ est plus importante que celle de $F_a$. Il convient donc, soit d'introduire dans la boucle de l'oscillateur (a) un élément introduisant un retard, dont l'effet se superposerait à celui du reste de la boucle, soit d'introduire dans la boucle de l'oscillateur (b) un élément introduisant un retard dont la variation avec la température soit en sens inverse de celle du reste de la boucle, de façon que la courbe de variation de la fréquence $F_b$ ait la même pente que la courbe, c'est ce deuxième cas qui est illustré ici. On cherche à obtenir la courbe C, parallèle à A. Le calcul suivant montre comment cette compensation est possible: la condition d'oscillation de tout oscillateur s'exprime par la relation $f\times T=n$ où n est un nombre pouvant prendre toutes valeurs entières, f la fréquence d'oscillation du mode »n« et T la somme des retards introduits par les différents éléments de la boucle: ligne, amplificateur, connexions. Le retard $T_0$ dû à la ligne étant le plus important, T est pratiquement égal à $T_0$. Lorsque l'un des paramètres auxquels sont sensibles les retards, et notamment $T_0$, varie, on obtient une variation relative de fréquence que l'on peut mesurer. Pour les variations de température

$$\frac{\delta f}{f} = - \frac{\delta T}{T} .$$

Pour l'oscillateur a:

$$\frac{\delta F_a}{F_a} = - \frac{\delta T_a}{T_a} .$$

Pour l'oscillateur b avec compensation, c'est-à-dire avec un élément introduisant un retard supplémentaire $\tau$:

$$\frac{\delta F_b}{F_b} = - \frac{\delta T_b + \delta \tau}{T_b + \tau}$$

La nécessité de la compensation provient de l'existence d'une différence non nulle

$$\frac{\delta T_a}{T_a} - \frac{\delta T_b}{T_b}$$

que l'on a mesuré. Le but de la compensation est de faire en sorte que

$$\frac{\delta T_b + \delta \tau}{T_b + \tau} = \frac{\delta T_a}{T_a} .$$

Connaissant

$$T_b, \frac{\delta T_a}{T_a} - \frac{\delta T_b}{T_b}$$

et la dérive $\frac{\delta \tau}{\tau}$ du câble employé, on peut déterminer le retard $\tau$, donc la longueur de câble nécessaire. En reprenant l'exemple précédent où $F_a \# F_b$ $\# 100$ MHz, donc

$$T_a \# T_b \# 1,5 \ \mu s \ \text{et} \ \frac{\delta T_a}{T_a} - \frac{\delta T_b}{T_b} = - 2.10^{-7}/°C$$

et en utilisant un câble pour lequel

$$\frac{\delta \tau}{\tau} = 10^{-3}/°C, \ \text{on a:} \ \frac{\delta \tau}{T_b + \tau} = \frac{\delta T_a}{T_a} - \frac{\delta T_b}{T_b} .$$

On obtient $\tau \# 0,3$ ns.

La vitesse de propagation dans un tel câble étant de l'ordre de 5 ns/m, la longueur de câble nécessaire est de l'ordre de la dizaine de cm. Le retard $\tau$ introduit un décalage $\Delta F_b$ de la fréquence $F_b$. D'après la relation

$$\frac{\Delta F_b}{F_b} = - \frac{\tau}{T_b} = - 2.10^{-4};$$

$F_b$ diminue donc d'environ 20 KHz et la différence

$F_a - F_b$ augmente de la même quantité. Cette augmentation de la fréquence du signal de sortie n'a généralement pas d'importance puisqu'il ne s'agit que d'un problème d'étalonnage du capteur. Toutefois, si, pour d'autres applications, on désire conserver à la différence $F_a - F_b$ sa valeur initiale, il est possible d'insérer dans la boucle de l'oscillateur (a) un élément introduisant un retard adéquat qui lui, ne soit pas sensible à la température. On peut utiliser par exemple un câble coaxial, dont l'isolant est du polytétrafluoréthylène, dont la dérive du retard est d'environ $-80 \times 10^{-6}/°C$. Il est par contre préférable de choisir pour l'élément compensateur, un matériau introduisant un retard très sensible avec la température, afin d'obtenir une longueur nécessaire la plus courte possible.

En pratique, pour mettre en oeuvre la procédé selon l'invention, il conviendra:

— d'effectuer les mesures de dérive en l'absence de compensation sur un des dispositifs auxquels elle est destinée:
— de choisir l'élément devant servir à cette compensation;
— de calculer approximativement la longueur nécessaire;
— d'introduire cet élément dans la boucle de l'oscillateur qui dérive le plus;
— par des mesures successives, d'ajuster finement la longueur de l'élément pour obtenir une dérive nulle dans la gamme de température choisie.

La longueur obtenue conviendra, généralement pour tous les dispositifs du même type fabriqués de la même façon. Parmi les matériaux susceptibles de convenir pour cette compensation, on peut citer certains câbles coaxiaux, à propagation guidée ou non, dont la nature de l'isolant détermine principalement la dérive: les câbles à isolant en polyéthylène ont une dérive d'environ $-250 \times 10^{-6}/°C$. Les câbles à isolant en polychlorure de vinyle (PVC) ont une dérive beaucoup plus importante: $-880 \times 10^{-6}/°C$. Ce type de câble est donc particulièrement avantageux.

Le schéma de la figure 1 ne représente qu'un exemple de mise en oeuvre de l'invention. Celle-ci peut être utilisée également avec des oscillateurs à résonateurs. Il n'est pas nécessaire que la disposition des lignes à retard ou des résonateurs soit telle que représentée sur la figure, ni que ceux-ci soient disposés sur le même substrat. Le procédé selon l'invention permet de compenser les dérives en température lorsque celles-ci sont à peu près linéaires.

## Revendications

1. Procédé de compensation des dérives en température dans un dispositif comprenant deux oscillateurs à ondes élastiques de surface (2a, 3a, 4a; 2b, 3b, 4b) comportant chacun une ligne à retard (2a, 3a; 2b, 3b) ou un résonateur agencé sur un substrat piézoélectrique commun (1) et des moyens mélangeurs (5) fournissant un signal de sortie (S) dont la fréquence est égale à la différence $(F_a - F_b)$ des fréquences d'oscillation des deux oscillateurs, ces deux oscillateurs présentant en raison de l'utilisation dudit substrat piézoélectrique commun des dérives en température de même signe et de valeurs très voisines, caractérisé en ce qu'il consiste à insérer dans la boucle de l'un au moins des oscillateurs un câble coaxial (60) introduisant un retard variable avec la température, dont la longueur est choisie de façon que la variation du retard avec la température compense la différence initiale entre les dérives thermiques des deux oscillateurs.

2. Procédé selon la revendication 1, caractérisé en ce que le câble (60) est à isolant en polychlourure de vinyle.

3. Procédé selon la revendication 1, caractérise en ce que le câble (60) est à isolant en polyéthylène.

4. Procédé selon la revendication 1, caractérisé en ce qu'en outre, un deuxième câble coaxial introduisant un retard présentant une dérive faible par rapport à la première est inséré dans la boucle de l'autre oscillateur de façon à conserver à la fréquence du signal de sortie sa valeur initiale.

5. Capteur de pression du type comprenant deux lignes à retard (2a, 3a, 2b, 3b) bouclées sur elles-mêmes respectivement par deux amplificateurs (4a, 4b) de manière à former deux boucles oscillatrices et des moyens mélangeurs (5) fournissant un signal de sortie (S) dont la fréquence est égale à la différence des fréquences d'oscillation desdites boucles; ces lignes étant disposées à la surface d'un substrat piézoélectrique (1) de façon à présenter des retards variant en sens inverse avec la pression à mesurer tout en présentant des dérives thermiques de mêmes signes et de valeurs très voisines, caractérisé en ce que la différence constatée entre les dérives thermiques des deux boucles oscillatrices est compensée par un câble coaxial (60) intercalé dans l'une au moins de celles-ci.

## Patentansprüche

1. Verfahren zur Kompensation der Temperaturabdrift einer Vorrichtung, die zwei elastische Oberflächenwellen erzeugende Oszillatoren (2a, 3a, 4a; 2b, 3b, 4b) umfaßt, die jeweils eine Verzögerungsleitung (2a, 3a; 2b, 3b) oder einen Resonator umfassen, der auf einem gemeinsamen piezoelektrischen Substrat (1) angeordnet ist, mit Mischeinrichtungen (5), die ein Ausgangssignal (S) liefern, dessen Frequenz gleich der Differenz (Fa – Fb) der Schwingungsfrequenzen der beiden Oszillatoren ist, wobei diese beiden Oszillatoren durch Verwendung des genannten gemeinsamen piezoelektrischen Substrates jeweils eine Temperaturabdrift desselben Vorzeichens und mit sehr stark aneinander angenäherten Werten aufweisen, dadurch gekennzeichnet, daß es darin besteht, in die Schleife wenigstens eines der Oszillatoren ein Koaxialkabel (60) einzufügen, das eine temperaturabhängige Verzögerung verursacht und dessen Länge so gewählt ist, daß die temperaturabhängige Verzögerung die anfängliche Temperaturabdriftdifferenz zwischen den beiden Oszillatoren kompensiert.

2. Verfahren nach Anspruch 1, dadurch gekennzeichnet, daß das Kabel (60) eine Isolierung aus Polyvinylchlorid aufweist.

3. Verfahren nach Anspruch 1, dadurch gekennzeichnet, daß das Kabel (60) eine Isolierung aus Polyäthylen aufweist.

4. Verfahren nach Anspruch 1, dadurch gekennzeichnet, daß ferner ein zweites Koaxialkabel, das eine im Vergleich zu dem ersten geringe Abdrift aufweist, in die Schleife des anderen Oszillators eingefügt ist, so daß die Frequenz des Ausgangssignals ihren anfänglichen Wert beibehält.

5. Druckaufnehmer mit zwei Verzögerungsleitungen (2a, 3a, 2b, 3b), die auf sich selbst jeweils durch einen Verstärker (4a, 4b) zurückgeschleift sind, so daß zwei Oszillatorschleifen gebildet sind, und mit Mischeinrichtungen (5), die ein Ausgangssignal (S) liefern, dessen Frequenz gleich der Differenz der Oszillatorfrequenzen der beiden Schleifen ist; wobei diese Leitungen an der Oberfläche eines piezoelektrischen Substrates (1) so angeordnet sind, daß sie Verzögerungen aufweisen, die sich mit dem zu messenden Druck in entgegengesetztem Sinne ändern, wobei sie jedoch Temperaturabdriften desselben Vorzeichens und mit sehr nahe beieinanderliegenden Werten aufweisen, dadurch gekennzeichnet, daß die festgestellte Differenz zwischen den Temperaturabdriften der beiden Oszillatorschleifen durch ein Koaxialkabel (60) kompensiert ist, das in wenigstens eine dieser Leitungen eingefügt ist.

## Claims

1. Method of compensating the temperature drifts of a device comprising two elastic surface wave oscillators (2a, 3a, 4a; 2b, 3b, 4b) each comprising a delay line (2a, 3a; 2b, 3b) or a resonator arranged on a common piezoelectric substrate (1), and mixing means (5) providing an output signal (S) the frequency of which is equal to the difference (Fa – Fb) of the oscillation frequencies of the two oscillators, these two oscillators, due to the use of said common piezoelectric substrate, having temperature drifts of the same sign and of very similar values, characterized in that is consists in inserting a coaxial cable (60) into the loop of at least one of the oscillators for introducing a temperature variable delay, the length of the coaxial cable being selected in a manner to have the initial difference between the temperature drifts of the two oscillators compensated by the temperature dependent variation of the delay.

2. Method in accordance with claim 1, characterized in that the cable (60) is of polyvinyl chloride insulation type.

3. Method in accordance with claim 1, characterized in that the cable (60) is of polyethylene insulation type.

4. Method in accordance with claim 1, characterized in that, in addition, a second coaxial cable introducing a delay having a low drift compared with the first is inserted into the loop of the other oscillator in a manner to maintain the frequency of the output signal at its initial value.

5. Pressure probe of the type comprising two delay lines (2a, 3a, 2b, 3b) which are looped by two amplifiers (4a, 4b) in a manner to form two oscillator loops, and mixing means (5) providing an output signal (S) the frequency of which is equal to the difference between the oscillation frequencies of said loops; these lines being arranged on the surface of a piezoelectric substrate (1) in a manner to have delays varying in opposite senses in response to the pressure to be measured, and having temperature drifts of the same signs and very similar values, characterized in that the detected difference between the temperature drifts of the two oscillator loops is compensated by a coaxial cable (60) inserted into at least one of these loops.

Fig.1

Fig.2